# EUROPÄISCHE PATENTSCHRIFT

(11) **EP 1 020 505 B1**
(45) Veröffentlichungstag und Bekanntmachung des Hinweises auf die Patenterteilung: **07.04.2004**
(21) Anmeldenummer: 00100393.8
(22) Anmeldetag: 08.01.2000
(51) Int. Cl.: C09J 7/00, C09J 7/02

(54) **Leitfähige Klebebänder und ihre Herstellung**
Conductive adhesive tapes and their preparation
Rubans adhésifs électroconducteurs et leur préparation

(30) Priorität: 14.01.1999 DE 19901140
(43) Veröffentlichungstag der Anmeldung: 19.07.2000
(73) Patentinhaber: Tesa AG, 20253 Hamburg (DE)
(72) Erfinder: Pfaff, Ronald, Dr., 22375 Hamburg (DE); Külper, Klaus, Dr., 25421 Pinneberg (DE); Zöllner, Stephan, Dr., 22043 Hamburg (DE)

(56) Entgegenhaltungen:
- WO-A-94/24704

## Beschreibung

Die Erfindung betrifft leitfähige Klebebänder und Ihre Herstellung

### Einleitung:

Elektronische Bauteile werden zunehmend kleiner, wodurch ihre Handhabung und Verarbeitung immer weiter erschwert wird. Vor allem beim Herstellen von elektrischen Kontakten zwischen den Bauteilen und/oder den Anschlüssen zeigt sich, daß herkömmliches Löten die entsprechenden Kontakte nicht mehr einfach und kostengünstig verbinden kann.

Die Verklebung elektronischer Bauteile durch elektrisch leitfähige Klebstoffschichten ist deshalb eine sich schnell entwickelnde Alternative.

Für den Bereich der elektrisch leitfähigen Klebebänder ist es Stand der Technik, leitfähige Pigmente wie Ruß, Metallpulver, ionische Verbindung u.ä., in Klebemassen einzusetzen. Bei ausreichenden Mengen berühren sich die Partikel untereinander und die Möglichkeit des Stromflusses von Partikel zu Partikel ist gegeben. Der Stromfluß ist hier nicht richtungsorientiert (isotrop); für spezielle Anwendungen wie elektronische Schalter, Kontaktierung von Leitern etc. besteht aber die Forderung, elektrische Leitfähigkeit nur in Dickenrichtung (z-Richtung) durch das Klebeband zu erzielen, dafür aber keine Leitfähigkeit in der flächigen Ausdehnung (x-y-Ebene) der Klebeschicht. In speziellen Fällen ist ferner sicherzustellen/zu fordern, daß die leitfähigen Stellen durch die Klebschicht (in z-Richtung)
- regelmäßig angeordnet und homogen verteilt sind, so dass beliebige Stellen des Klebebandes identisch verwendet werden können und zu gleichen Ergebnissen führen;
- kleine Querschnitte haben, um auch im Bereich der Elektronik eng zusammenliegende Leiterbahnen selektiv ohne Gefahr von Kurzschlüssen verbinden zu können und dass
- die leitfähigen Stellen untereinander isoliert sind, indem die Zwischenräume mit nicht leitenden Materialien ausgefüllt sind.

### Stand der Technik

Einige bekannte Systeme ergeben zwar anisotrope Leitfähigkeit in z-Richtung, eine homogene Verteilung und/oder eine hohe räumliche Auflösung der Kontaktmöglichkeiten ist jedoch nicht sichergestellt. Das US-Patent 3,475,213 beschreibt statistisch verteilte sphärische Partikel, die ganz aus einem leitfähigen Metall bestehen oder mit einer elektrisch leitfähigen Schicht versehen sind. Die besten Ergebnisse werden mit Partikeln erzielt, die nur wenig kleiner sind als die Dicke der Klebemasseschicht.

Gemäss US-Patent 5,300,340 werden durch ein spezielles Herstellverfahren mit einer rotierenden Trommel elektrisch leitfähige Partikel in die Klebmasse platziert. Zum einen müssen die dazu notwendigen leitend beschichteten Glaskugeln von hoher Qualität bezüglich Teilchengrößenverteilung sein, zum anderen ist die Herstelltechnik sehr aufwendig und eine fehlerfreie Auf- oder Einbringmöglichkeit der leitenden Kugeln in die Klebeschicht kaum möglich: jede Fehlstelle in der Fläche bedeutet dabei aber, dass bei späteren Anwendungen an dieser Stelle ein leitender Kontakt nicht zustande kommt, d.h. eine Fehlfunktion vorliegt. Dies zu vermeiden, bedingt ein sehr aufwendiges und kostenintensives Herstellverfahren sowohl der Materialien als auch der technischen Realisierung.

Die WO 94/24704 A1 beschreibt in z-Richtung elektrisch leitfähige Beschichtungen, die strukturierte leitfähige Bereiche neben Bereichen mit Klebmasse aufweisen. Es werden ausschließlich thermisch aktivierbare Klebstoffe verwendet, Selbstklebemasse finden keine Erwähnung.

Aufgabe der Erfindung war es deshalb, geeignete Klebebänder zu schaffen und insbesondere für die hohen Anforderungen an anisotrop elektrisch leitfähige Klebebänder ein sicheres, universell nutzbares und ökonomisches Herstellverfahren zu finden. In Versuchen zeigte sich überraschend der Weg als geeignet, die Drucktechnologie, insbesondere die Siebdruck-Technologie für die Herstellung in der z-Richtung leitenden Bereiche in der Klebeschicht zu nutzen.

Die Siebdrucktechnologie wird nicht nur als Drucktechnologie eingesetzt, sondern stellt auch eine spezielle Beschichtungstechnologie dar. So werden Hotmelt-Kleber seit Jahren im Textilbereich mittels Siebdruck aufgebracht. Aus EP 356 777, EP 328 925 und EP 149135 ist ferner bekannt, daß mit der Siebdruck-Technologie durch Aufbringen von regelmäßigen, gezielten Strukturen von Selbstklebemassen ganz spezielle Eigenschaften wie Reversibilität, gesteuerte Klebkräfte, blasenfreie Verklebungen und flächigen Materialien etc. erzielt werden können.

Im Bereich der Elektrotechnik/Elektronik werden mittels Siebdruck Leiterbahnen für Schaltungen gedruckt bei Einsatz von käuflichen Leitpasten wie z.B. Ablebond 8175 der Firma Ablestik werden auf flächigen Untergründen wie Leiterplatten Bahnen gedruckt, wobei generell für die Dimensionen gilt: Länge » Breite > Höhe. Erfindungsgemäß werden nun an sich bekannte Leitpasten mit dieser Technik dazu verwandt, leitfähige, dreidimensionale Gebilde auf einem Träger zu drucken.

Über die Auswahl der Siebe zum einen und Einstellung einer entsprechenden Rheologie der Leitpaste zum anderen lassen sich die Geometrien und Verteilungen in weiteren Bereichen einstellen.

Die in z-Richtung leitfähigen Bereiche in der Klebeschicht werden vorher mit Leitpasten insbesondere im Siebdruck erstellt, die Zwischenräume anschließend mit Selbstklebemasse ausgefüllt. Als Träger können leitfähige flächige Materialien wie Metallfolien gewählt werden oder aber Trennfolien/-papiere. Im ersten Falle entstehen direkt leitfähige Klebebänder z.B. für Shielding-Anwendungen, um zweiten Fall beidseitig klebende, elektrisch leitfähige Transfer Fixe für Kontaktierungs- und Verbindungsanwendungen.

Gegenüber dem Stand der Technik ist das erfindungsgemäße Verfahren zur Herstellung von leitfähigen Klebebändern vorteilhaft, einfach und leicht zu beherrschen.

Daneben kann die Leitpaste auch direkt auf die Haftklebeschicht z.B. im Siebdruck aufgetragen werden. Bei genügend großem Festigkeitsunterschied von getrockneter Leitpaste und getrockneter Haftklebeschicht lassen sich die leitfähigen Strukturen in die Klebemasse hineindrücken. Bei geeigneten Höhen von Haftklebeschicht und den leitfähigen Gebilden läßt sich so leicht ein anisotrop leitfähiges Transfer Fix oder Klebeband erhalten.

Für die Beschichtung kann insbesondere sowohl der Flachsiebdruck als auch der kontinuierliche Rotationssiebdruck gewählt werden; für die Herstellung von Klebebändern als Rollenmaterial ist jedoch der rotative Siebdruck zu bevorzugen, da hier ein rapportfreies Beschichten von Rolle auf Rolle möglich ist

Um Beschichtungshöhe in derselben Art wie die Schichtdicke der späteren Klebeschicht zu erhalten, nämlich insbesondere zwischen 10 bis 200 µm, bevorzugt 25 bis 100 µm, sind Siebe zu wählen, deren Wandstärke in derselben Größenordnung liegt; hier bieten sich galvanisch hergestellte Siebe an, wie sie z.B. von der Firma Storck Screens / NL in großer Vielfalt hergestellt und vertrieben werden.

Während sich u.a. über die Wandungsstärke die spätere Höhe des Leitblockes (bedeutet im weiteren das einzelne, diskrete, leitfähige Gebilde) beeinflussen läßt, sind über die Lochanzahl und das Steg/Loch-Verhältnis der gewählten Siebe die Anzahl der Leitblöcke pro Fläche sowie ihr Querschnitt steuerbar.

Anstelle des Einsatzes von kostspieligen, meist silberbeschichteten Glaskugeln gemäß Stand der Technik kann bei der erfindungsgemäßen Ausführung auf käufliche Leiterpasten zurückgegriffen werden, wie sie sich seit Jahren im Einsatz befinden, so von Firma Haraeus: PC860005 oder Varianten mit höherer Härtungstemperatur der Firma Ablestick: Ablebond-Pasten mit verschiedenen Füllstoffen (z.B. Silber, Gold, Kupfer) und verschiedenen Aushärtungstemperaturen, z.B. Ablebond 84-1 LMITI1.

Je nach Art der enthaltenen Füllstoffe lassen sich unterschiedliche Leitfähigkeiten erzielen: bei nur mäßigen Anforderungen reichen aluminium- oder nickelbasierte Pasten aus, ansonsten stehen u.a. kupfer-, silber- und goldhaltige Pasten zur Verfügung. Da die Leitpasten flüssig oder pastös sind, ist die Viskosität und Rheologie so zu wählen, daß nach dem Drucken, insbesondere nach dem Durchpressen durch das Sieb die durch das Siebloch vorgeprägte geometrische Form möglichst weitgehend aufrecht erhalten wird und kein Verlaufen stattfindet, wie es für flächige Strukturen erstrebenswert ist hohe Viskosität sowie bei thixotropen Verhalten der Pasten eine möglichst kurze Relaxationszeit ergeben gute Ergebnisse. Unterstützt werden kann dies, indem die Binder der Leitpasten sich zumindest oberflächlich nach dem Beschichtungsvorgang verfestigen und so die ursprüngliche geometrische Form fixieren: dies kann durch Verdunstung von niedrig siedenen Lösemittel, durch Temperaturschock ausgelöste chemische Reaktion oder aber bevorzugt durch Strahlung und hier besonders UV-Strahlung erfolgen.

Anzustreben sind geometrische Formen wie zylinderförmige Gebilde, da hier in beide zu verbindende Richtungen größere Kontaktflächen zur Verfügung stehen und damit die Wahrscheinlichkeit für eine leitfähige Verbindung sehr hoch ist.

Die Beschichtung der Leitblöcke kann sowohl direkt auf elektrisch leitfähige Trägermaterialien erfolgen, wobei neben Metallfolien aus Aluminium, Kupfer, Zinn, Blei, Eisen etc. auch leitfähig ausgerüstete Gewebe und Vliese eingesetzt werden können. Ebenso ist eine Beschichtung auf Trennpapieren oder Trennfolien möglich.

Die Herstellung des Vorproduktes endet damit, daß die Zwischenräume mit geeigneten Selbstklebemassen gefüllt werden - je nach Anforderung an das spätere Klebeband können Selbstklebemassen mit unterschiedlichen Eigenschaftsprofilen zum Einsatz kommen, wie sie z.B. aus dem Handel, z.B. der ***tesa***-Produktpalette bekannt sind. Das Schneiden und Ablängen zu den vom Endverbraucher gewünschten Abmessungen ist der letzte Schritt zu dem fertigen elektrisch leitfähigen Klebeband.

Neben der sehr homogenen Verteilung von Leiterblöcken über die gesamte Fläche, wie oben näher beschrieben, bietet insbesondere die Siebdruck-Technologie noch weitere Möglichkeiten. Indem auf den Sieben ein Dessin aufgebracht wird, können genau definierte Bereiche mit derartigen Leiterblöcken versehen werden, andere aber frei davon bleiben. Nach der anschließenden Beschichtung der freien Räume mit Selbstklebemassen können somit größere Flächengebilde erzeugt werden, die in bestimmten Bereichen in z-Richtung anisotrop leitfähig und klebend sind, in anderen Bereichen aber nur klebend. Als Anwendungen seien beispielsweise Tastaturfolien genannt, wo im Bereich der Tasten selektiv anisotrope Leitfähigkeit gegeben ist, in den Zwischenbereichen jedoch es sich um ein normales doppelseitig klebendes Klebeband handelt, mit welchem die Folientastatur auf dem Untergrund fixiert wird. Hier bietet sich nicht nur die Möglichkeit, zwei bisher getrennte Systeme (Kontaktierung für Folienschalter der Tastaturfolie) in einem System zu kombinieren, auch wird gegenüber der Alternative, die gesamte Tastaturfolie mit elektrisch leitfähigem, doppelseitig klebendem Film zu fixieren, erheblich an leitfähigen Pigmenten gespart.

### Beispiel 1

Verwendet wurde eine Silberleitpaste, die Heraeus-Paste PC 860005. Viskosität: 46,9 Pa.s (Schergefälle 30,0/s; 25 C°). Sie wurde mit einem Sieb der Firma Storck (NL) Typ: ST 70, Mesh-Zahl 70 (mit einer Dicke von 100 µm, einem Lochdurchmesser von 140 µm und einem Lochabstand von 220 µm) auf ein silikonisiertes Trennpapier gedruckt und wenige Minuten bei 110°C gehärtet.

Es entstehen dabei kegelstumpfförmige Partikel mit einer maximalen Dicke von ca. 85 µm und einer maximalen Breite von ca. 200 mm. Der minimale Segmentabstand beträgt 150 µm.

Ein Haftkleber (VCA 456 (FG 45%) + 20% Klebharz DT 110 + 0,6% Vernetzer Al-Chelat), einem Terpolymer aus 2-Ethylhexylacrylat, Butylacrylat und Acrylsäure (47:47:6) wurde aus Lösung Aceton/Benzin 60,95 als Film auf Trennpapier beschichtet und das Lösungsmittel abgedampft. Diese Klebstoffschicht (Dicke 50 µm) wurde auf die vorstehend gedruckte und gehärtete Silberleitpaste auf dem silikonisierten Trennpapier kaschiert und mit einer silikonisierten Polyesterfolie abgedeckt. Unter leichtem Druck entsteht eine Klebemasseschicht mit elektrisch leitfähigen Segmenten in der Form leicht abgeflachter Kegel, eingebettet in den Haftkleber.

Die Klebkraft des Klebestreifens beträgt 3,9 N/cm. ASTM D1000, die Dicke ca. 50 µm und der Durchgangswiderstand beträgt 0,13 mΩ. ASTM 2739.

### Beispiel 2

Wie Beispiel 1 mit dem Unterschied, daß die Klebstoffschicht erzeugt wird, indem eine Lösung des Klebstoffs gemäß Beispiel 1 Klebkraft 4,0 N.cm, Dicke ca. 60 µm, Durchgangswiderstand 0,18 m Ω auf die bedruckte und gehärtete Leitpasteschicht gemäß Beispiel 1 aufgetragen und anschließend getrocknet wird.

In den Figuren sind geeignete Ausführungsformen erfindungsgemäßer Klebebänder in idealisierter Form dargestellt. Es zeigen
- Fig. 1: einen Querschnitt durch ein solches Klebeband,
- Fig. 2: eine Draufsicht auf einen Abschnitt eines Klebebandes gemäß Fig. 1, und
- Fig. 3: einen Querschnitt durch ein weiteres solches Klebeband.

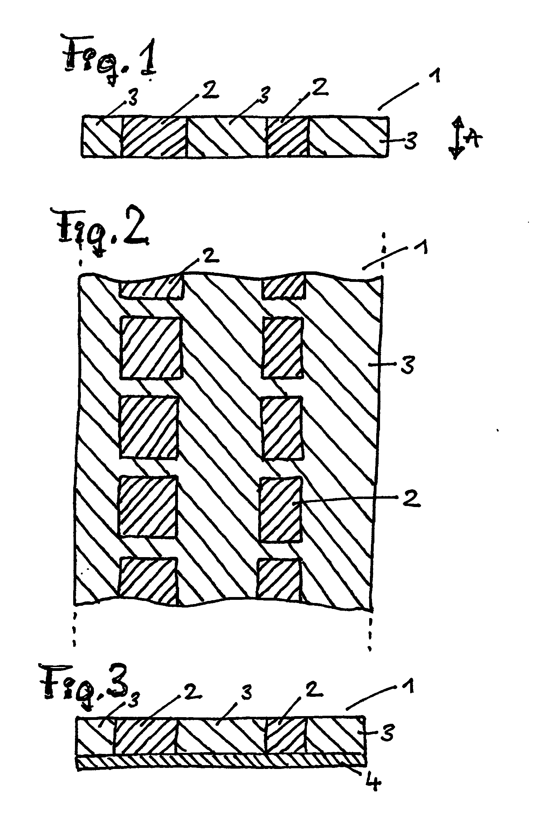

Im einzelnen zeigt Fig. 1 ein Klebeband 1 mit leitfähigen Bereichen 2, die von Klebmasse 3 umgeben sind. Fig. 2 zeigt, wie diese Bereiche 2 von Klebmasse 3 umgeben und damit in x-y-Ebene nicht-leitend ausgebildet sind, leitend jedoch in z-Richtung (Pfeil A, in Figur 1). Figur 3 zeigt eine weitere Variante eines solches Klebebandes 1, bei dem auf der Unterseite ein leitfähiger Träger 4 aufkaschiert ist Über diesen Träger 4 ist dieses Klebeband auch in der x-y Ebene leitend. - Bevorzugt sind vor allem auch solche Klebebänder, bei denen die leitfähigen Bereiche 2 rund ausgebildet sind.

## Patentansprüche

1. Leitfähiges Klebeband (1) **gekennzeichnet durch**
a) in z-Richtung (in Richtung der Dicke des Klebebandes; A) anisotrop leitfähige Bereiche (2), die
b) aus Leitpasten gedruckt sind, wobei
c) die Zwischenräume zwischen den leitfähigen Bereichen (2) mit einer Selbstklebemasse (3) ausgefüllt sind.

2. Klebeband nach Anspruch 1, **dadurch gekennzeichnet, dass** die leitfähigen Bereiche (2) thermisch oder insbesondere elektrisch leitfähige Bereiche (2) sind.

3. Klebeband nach Anspruch 1, **dadurch gekennzeichnet, dass** die leitfähigen Bereiche (2) aus Leitpasten im Siebdruck gedruckt sind.

4. Klebeband nach Anspruch 1, **dadurch gekennzeichnet, dass** das Klebeband (1) 10 - 200 µm dick ist, wobei sowohl die Selbstklebemasse (3) als auch die leitfähigen Bereiche (2) 10 - 200 µm dick sind und zugleich gleich dick sind und insbesondere nicht mehr als 20 µm von der Selbstklebemasse-Schichtdicke abweichen.

5. Klebeband nach Anspruch 1, **dadurch gekennzeichnet, dass** die leitfähigen Bereiche (2) aus Leitpasten auf Basis Aluminium, Nickel, Kupfer, Silber oder Gold bzw. aus Legierungen insbesondere solcher Metalle gedruckt sind.

6. Klebeband nach Anspruch 1, **dadurch gekennzeichnet, dass** die leitfähigen Bereiche (2) verfestigt und fixiert sind, insbesondere thermisch und/oder durch Strahlung, insbesondere UV-Strahlung.

7. Klebeband nach Anspruch 1, **dadurch gekennzeichnet, dass** die Selbstklebemasse (3) eine solche auf Lösemittelbasis oder ein hot-melt ist.

8. Klebeband nach Anspruch 1, **dadurch gekennzeichnet, dass** die Selbstklebemasse (3) eine solche auf Acrylat-Basis ist.

9. Klebeband nach Anspruch 1, **dadurch gekennzeichnet, dass** das Klebeband ein Trennpapier/Trennfolie als Stützträger aufweist.

10. Klebeband nach Anspruch 1, **dadurch gekennzeichnet, dass** das Klebeband (1) einseitig einen Träger (4) aufweist, insbesondere einen solchen, der leitfähig ist.

11. Verfahren zur Herstellung eines Klebebandes nach einem der Ansprüche 1 - 10, **dadurch gekennzeichnet, dass** leitfähige Bereiche aus Leitpasten auf einen Hilfsträger gedruckt werden, worauf die gedruckten Bereiche verfestigt und fixiert werden, insbesondere thermisch und/oder durch Strahlung, worauf eine Selbstklebemasse in derselben Schichtdicke wie die leitfähigen Bereiche in deren Zwischenräume auf den Hilfsträger beschichtet und ggf. von Lösungsmittel befreit wird, worauf der Hilfsträger entfernt und ggf. ein leitfähiger Träger aufkaschiert wird, oder es wird die Leitpaste zu leitfähigen Bereichen auf die Selbstklebemasse gedruckt, verfestigt und fixiert und dann in die Selbstklebemasse hineingedrückt, ggf. wird dann ein leitfähiger Träger aufkaschiert.

## Claims

1. Conductive adhesive tape (1) **characterized by**
a) regions (2) which are anisotropically conductive in the z direction (in the direction of the thickness of the adhesive tape; A) and which
b) are printed from conducting pastes, where
c) the areas in between the conductive regions (2) are filled with a self-adhesive composition (3).

2. Adhesive tape according to Claim 1, **characterized in that** the conductive regions (2) are thermally or, in particular, electrically conductive regions (2).

3. Adhesive tape according to Claim 1, **characterized in that** the conductive regions (2) are printed from conducting pastes by screen printing.

4. Adhesive tape according to Claim 1, **characterized in that** the adhesive tape (1) is 10-200 µm thick, with both the self-adhesive composition (3) and the conductive regions (2) being 10-200 µm thick and also being of equal thickness and in particular deviating by not more than 20 µm from the thickness of the layer of self-adhesive composition.

5. Adhesive tape according to Claim 1, **characterized in that** the conductive regions (2) are printed from conducting pastes based on aluminium, nickel, copper, silver or gold or of alloys in particular of such metals.

6. Adhesive tape according to Claim 1, **characterized in that** the conductive regions (2) are solidified and fixed, in particular thermally and/or by radiation, especially UV radiation.

7. Adhesive tape according to Claim 1, **characterized in that** the self-adhesive composition (3) is a solvent-based composition or a hotmelt.

8. Adhesive tape according to Claim 1, **characterized in that** the self-adhesive composition (3) is an acrylate-based composition.

9. Adhesive tape according to Claim 1, **characterized in that** the adhesive tape comprises a release paper/release film as support.

10. Adhesive tape according to Claim 1, **characterized in that** the adhesive tape (1) has on one side a backing (4), in particular a conductive backing.

11. Process for producing an adhesive tape according to one of Claims 1-10, **characterized in that** conductive regions are printed from conducting pastes on an auxiliary support, and then the printed regions are solidified and fixed, in particular thermally and/or by radiation, and then a self-adhesive composition is coated onto the auxiliary support having the same layer thickness as the conductive regions, in the areas between those regions, and is freed, where appropriate, from solvent, and then the auxiliary support is removed and, if desired, a conductive backing is laminated on, or the conducting paste is printed to form conductive regions on the self-adhesive composition, and is solidified and fixed and then pressed into the self-adhesive composition, and then, if desired, a conductive backing is laminated on.

## Revendications

1. Bande adhésive conductible (1), **caractérisée par**
a) dans le sens de l'axe z (dans le sens de l'épaisseur de la bande adhésive ; A) des zones conductibles (2) anisotropes qui
b) sont imprimées avec des pâtes conductrices,
c) les espaces intermédiaires entre les zones conductibles (2) étant remplies d'une masse auto-adhésive (3).

2. Bande adhésive selon la revendication 1, **caractérisée en ce que** les zones conductibles (2) sont des zones (2) thermiquement ou en particulier électriquement conductibles.

3. Bande adhésive selon la revendication 1, **caractérisée en ce que** les zones conductibles (2) sont imprimées avec des pâtes conductrices par sérigraphie.

4. Bande adhésive selon la revendication 1, **caractérisée en ce que** la bande adhésive (1) présente une épaisseur de 10 à 200 µm, la masse auto-adhésive (3) ainsi que les zones conductibles (2) présentant toutes les deux une épaisseur de 10 à 200 µm et présentant la même épaisseur ou l'épaisseur desdites zones conductibles (2) ne variant pas de plus de 20 µm par rapport à l'épaisseur de la couche de masse auto-adhésive.

5. Bande adhésive selon la revendication 1, **caractérisée en ce que** les zones conductibles (2) sont imprimées avec des pâtes conductrices à base d'aluminium, de nickel, de cuivre, d'argent ou d'or ou d'alliages, en particulier de ces métaux.

6. Bande adhésive selon la revendication 1, **caractérisée en ce que** les zones conductibles (2) sont solidifiées et fixées, en particulier thermiquement et/ou par irradiation, en particulier par des rayons UV.

7. Bande adhésive selon la revendication 1, **caractérisée en ce que** la masse auto-adhésive (3) est une masse auto-adhésive à base de solvant ou une masse fusible à chaud.

8. Bande adhésive selon la revendication 1, **caractérisée en ce que** la masse auto-adhésive (3) est une masse auto-adhésive à base d'acrylate.

9. Bande adhésive selon la revendication 1, **caractérisée en ce que** la bande adhésive présente un papier/une feuille de séparation comme support d'appui.

10. Bande adhésive selon la revendication 1, **caractérisée en ce que** la bande adhésive (1) présente un support (4), en particulier un support qui est conductible.

11. Procédé pour la préparation d'une bande adhésive selon l'une quelconque des revendications 1 à 10, **caractérisé en ce que** des zones conductibles sont imprimées en pâtes conductrices sur un support auxiliaire, suite à quoi les zones imprimées sont solidifiées et fixées, en particulier thermiquement et/ou par irradiation, puis on revêt le support auxiliaire d'une masse auto-adhésive avec la même épaisseur de couche que les zones conductibles dans les espaces intermédiaires entre celles-ci et on évacue éventuellement le solvant, puis le support auxiliaire est enlevé et on contre-colle le cas échéant un support conductible, ou la pâte conductrice est imprimée, solidifiée et fixée en zones conductibles sur la masse auto-adhésive, puis enfoncée dans la masse auto-adhésive, puis on contre-colle le cas échéant un support conductible.
